# EUROPÄISCHE PATENTANMELDUNG

(11) **EP 3 680 247 A1**
(43) Veröffentlichungstag der Anmeldung: **15.07.2020**
(21) Anmeldenummer: 19150816.7
(22) Anmeldetag: 08.01.2019
(51) Int. Cl.: C07F 17/02, C23C 16/00

(54) **METALLORGANISCHE VERBINDUNGEN**

(71) Anmelder: UMICORE AG & CO. KG, 63457 Hanau-Wolfgang (DE)
(72) Erfinder: SUNDERMEYER, Joerg, 35041 Marburg (DE); Schumann, Henrik, 35796 Weinbach (DE)
(74) Vertreter: Clauswitz, Kai-Uwe Wolfram

(57) **Zusammenfassung**

Es werden Rutheniumkomplexe der Formel (I) beschrieben:

[(aren)RuXL] Formel (I)

wobei der Rutheniumkomplex folgende Liganden aufweist:
(aren) = Aren, das optional substituiert sein kann,
X = H oder C₁-C₈ Kohlenwasserstoffrest, und
L = R²N-CR¹=NR³,
wobei
R¹ ausgewählt ist aus H, C₁-C₈ Kohlenwasserstoffrest, der optional substituiert sein kann, und -NR⁴R⁵, wobei R⁴ und R⁵ unabhängig voneinander ausgewählt sind aus H und C₁-C₈ Kohlenwasserstoffresten, die optional substituiert sein können,
R² und R³ unabhängig voneinander ausgewählt sind aus C₁-C₈ Kohlenwasserstoffresten, die optional substituiert sein können, wobei R² und R³ gleich oder verschieden voneinander sind, und
R¹ mit R², R¹ mit R³ und/oder R² mit R³ direkt verknüpft sein kann.

## Beschreibung

Die Erfindung betrifft Rutheniumkomplexe, die mit einer Formel (I) beschrieben werden. Außerdem betrifft die Erfindung Verfahren zur Herstellung solcher Rutheniumkomplexe und deren Verwendung zur Abscheidung von Ruthenium in CVD-Verfahren und ALD-Verfahren. Zudem betrifft die Erfindung Verfahren, in denen solche Rutheniumkomplexe als Präkursor zur Herstellung einer Rutheniumschicht eingesetzt werden. Außerdem betrifft die Erfindung ruthenierte Oberflächen, welche durch Abscheiden von Ruthenium auf einer Oberfläche aus einer Gasphase erhältlich sind, wobei die Gasphase einen solchen Rutheniumkomplex umfasst.

### Stand der Technik

CVD-Verfahren (CVD = *chemical vapor deposition*) und ALD-Verfahren (ALD = *atomic layer deposition*) werden eingesetzt, um Substrate zu beschichten. Dabei wird ein erwünschtes Material aus der Gasphase auf einer Oberfläche eines Substrats abgeschieden. In der Gasphase liegt das erwünschte Material typischerweise in Form einer Vorläufersubstanz vor, die auch als Präkursor bezeichnet wird. In Abhängigkeit von dem abzuscheidenden Material kommen unterschiedliche Präkursoren zum Einsatz.

Als Präkursoren für Metalle allgemein werden im Stand der Technik zum Beispiel Metallkomplexe eingesetzt. In EP 3 026 055 A1 werden zum Beispiel N-Amino-Guanidinat-Komplexe verschiedener Metalle beschrieben, die unter anderem bei der Herstellung dünner Schichten etwa durch CVD Verwendung finden. Die DE 10 2011 012 515 A1 beschreibt Metallkomplexe mit N-Amino-Amidinat-Liganden, welche ebenfalls in Gasphasen-Dünnschichtverfahren wie CVD verwendet werden.

Als Präkursoren für Ruthenium werden im Stand der Technik unter anderem Rutheniumkomplexe eingesetzt. Aus US 7,737,290 B2 ist im Zusammenhang mit der Bildung von Metallfilmen unter Verwendung von Metallamidinaten eine Synthese von Tris(N,N'-diisopropylacetamidinato)ruthenium bekannt. EP 1884 517 A1 betrifft metallorganische Verbindungen, die als Präkursoren für CVD- und ALD-Verfahren geeignet sein sollen. In einem theoretischen Beispiel von EP 1 884 517 A1 wird eine Darstellung von (1-Dimethylamino)allyl(η⁶-*p*-cymol)rutheniumdiisopropylacetamidinat beschrieben. Als Vorstufe wird dabei eine theoretische Darstellung von [(p-Cymol)RuCl(N,N'-bis-iso-propylaminoacetamidinat)] beschrieben.

Weitere Beispiele für Rutheniumkomplexe als Präkursoren für Ruthenium in Gasphasen-Dünnschichtverfahren sind [(Methylcyclopendadienyl)₂Ru], [(Dimethylpentadienyl)₂Ru] und [(Aren)Ru(1,4-Diaza-1,3-butadien)].

Einige der im Stand der Technik eingesetzten Präkursoren für Ruthenium sind noch verbesserungsbedürftig. Zum Teil weisen die Präkursoren Nachteile wie eine geringe synthetische Zugänglichkeit, zu hohe Zersetzungstemperaturen und zu hohe Einbauraten von Kohlenstoff und anderer Verunreinigungen bei der Herstellung dünner Schichten auf. Einige der im Stand der Technik eingesetzten Präkursoren für Ruthenium sind zudem für ALD-Verfahren ungeeignet, da es zu einer bevorzugten Abspaltung nur eines schwach gebundenen Liganden dieser Präkursoren kommt. Weitere Nachteile einiger Präkursoren bestehen darin, dass sie zu wenig flüchtig sind und/oder bei Raumtemperatur nicht flüssig sind.

Bei einer industriellen Anwendung ist es daneben von großem Interesse, dass bei der Synthese von Präkursoren für Ruthenium möglichst wenige Stufen zum gewünschten Produkt führen. Außerdem sollten harsche Reaktionsbedingungen vermieden werden. Die Präkursoren sollten zudem in möglichst hohen, optimierten Ausbeuten erhalten werden. Besonders vorteilhaft ist es, wenn die Präkursoren bei Raumtemperatur lange haltbar sind. Zudem sollten die Präkursoren selbst ein Erwärmen eines Vorratsgefäßes für CVD- oder ALD-Verfahren wie etwa eines sogenannten Bubblers auf Temperaturen bis 100°C zwecks Erhöhung des Dampfdruckes problemlos überstehen. Bei weiter erhöhten Temperaturen sollten die Präkursoren dann aber unter typischen Bedingungen von CVD- oder ALD-Verfahren wie insbesondere unter erhöhten Temperaturen exotherm zerfallen.

### Aufgabe der Erfindung

Der Erfindung liegt als eine Aufgabe zugrunde, Rutheniumkomplexe bereitzustellen, welche die oben beschriebenen Nachteile zumindest teilweise und möglichst ganz überwinden.

Der Erfindung liegt als eine weitere Aufgabe zugrunde, Rutheniumkomplexe bereitzustellen, welche die oben beschriebenen wünschenswerten Eigenschaften aufweisen. Die Rutheniumkomplexe sollen eine hohe Flüchtigkeit aufweisen, bei Raumtemperatur möglichst flüssig und bei höheren Temperaturen noch stabil sein, aber keine zu hohen Zersetzungstemperaturen haben.

Aufgabe der Erfindung ist auch, eine gute synthetische Zugänglichkeit der Rutheniumkomplexe zu gewährleisten, insbesondere über Synthesen mit wenigen Stufen. Aufgabe ist es dabei auch, dass die Synthese der Rutheniumkomplexe keine harschen Reaktionsbedingungen erfordert und möglichst hohe Ausbeuten liefert.

### Offenbarung der Erfindung

Überraschenderweise werden die der Erfindung zugrunde liegenden Aufgaben gelöst durch Rutheniumkomplexe gemäß den Patentansprüchen.

Gegenstand der Erfindung ist ein Rutheniumkomplex der Formel (I):

[(aren)RuXL] Formel (I)

wobei der Rutheniumkomplex folgende Liganden aufweist:
- (aren) =: Aren, das optional substituiert sein kann,
- X =: H oder C₁-C₈ Kohlenwasserstoffrest, und
- L =: R²N-CR¹=NR³, wobei
R¹ ausgewählt ist aus H, C₁-C₈ Kohlenwasserstoffrest, der optional substituiert sein kann, und -NR⁴R⁵, wobei R⁴ und R⁵ unabhängig voneinander ausgewählt sind aus H und C₁-C₈ Kohlenwasserstoffresten, die optional substituiert sein können,
R² und R³ unabhängig voneinander ausgewählt sind aus C₁-C₈ Kohlenwasserstoffresten, die optional substituiert sein können, wobei R² und R³ gleich oder verschieden voneinander sind, und
R¹ mit R², R¹ mit R³ und/oder R² mit R³ direkt verknüpft sein kann.

Rutheniumkomplexe der Formel (I) können flüchtig und bei Raumtemperatur flüssig sein. Rutheniumkomplexe der Formel (I) können bei höheren Temperaturen noch stabil sein und keine zu hohen Zersetzungstemperaturen aufweisen. Rutheniumkomplexe der Formel (I) können über wenige Stufen unter milden Bedingungen in hohen Ausbeuten dargestellt werden.

Ein Rutheniumkomplex der Formel (I) ist neutral, was sich im Fehlen einer Ladungsangabe an der eckigen Klammer widerspiegelt.

Das Ruthenium (Ru) bildet in dem Komplex mit der Formel (I) das Zentralatom, (aren), X und L bilden die Liganden des Komplexes.

Mit "Aren" wird nach der *International Union of Pure and Applied* Chemistry ein aromatischer Kohlenwasserstoff bezeichnet. Arene umfassen dabei sowohl monocyclische als auch polycyclische aromatische Kohlenwasserstoffe. Diese aromatischen Kohlenwasserstoffe können optional substituiert sein. Im nachfolgend angegebenen allgemeinen Reaktionsschema werden optionale Substituenten am Liganden (aren) mit (R⁶)ₙ bezeichnet. Der Index n kann bevorzugt 0, 1, 2, 3, 4, 5 oder 6 sein, mehr bevorzugt 0 oder 2, insbesondere bevorzugt 2. Erfindungsgemäß ist R⁶ bevorzugt aus Kohlenwasserstoffresten, Hydroxygruppen, Alkoxygruppen, Aminogruppen und Halogenen ausgewählt, mehr bevorzugt aus Kohlenwasserstoffresten.

Der Ligand X ist entweder ein Hydridoligand (H), oder ein C₁-C₈ Kohlenwasserstoffrest, bevorzugt H oder ein C₁-C₆ Kohlenwasserstoffrest, noch mehr bevorzugt H oder ein C₁-C₄ Kohlenwasserstoffrest.

Im Rahmen der vorliegenden Erfindung bezieht sich ein Kohlenwasserstoffrest wie üblich auf einen Rest, der ausschließlich aus Kohlenstoff und Wasserstoff aufgebaut ist. Ein Kohlenwasserstoffrest, der optional substituiert sein kann, bezieht sich im Rahmen der vorliegenden Erfindung auf einen Rest, der von Kohlenstoff und Wasserstoff verschiedene Atome (Heteroatome) als Substituenten aufweisen kann.

Im Rahmen der vorliegenden Erfindung bezieht sich ein C₁-C₈ Kohlenwasserstoffrest auf einen Kohlenwasserstoffrest, der 1 bis 8 Kohlenstoffatome aufweist, also 1, 2, 3, 4, 5, 6, 7 oder 8 Kohlenstoffatome aufweist. Im Rahmen der vorliegenden Erfindung bezieht sich ein C₁-C₆ Kohlenwasserstoffrest auf einen Kohlenwasserstoffrest, der 1 bis 6 Kohlenstoffatome aufweist, also 1, 2, 3, 4, 5, oder 6 Kohlenstoffatome aufweist. Im Rahmen der vorliegenden Erfindung bezieht sich ein C₁-C₄ Kohlenwasserstoffrest auf einen Kohlenwasserstoffrest, der 1 bis 4 Kohlenstoffatome aufweist, also 1, 2, 3 oder 4 Kohlenstoffatome aufweist.

Im Rahmen der vorliegenden Erfindung bezieht sich ein Kohlenwasserstoffrest allgemein auf einen Kohlenwasserstoffrest, der gesättigt oder ungesättigt sein kann. Bevorzugt sind gesättigte Kohlenwasserstoffreste.

Im Rahmen der vorliegenden Erfindung bezieht sich ein Kohlenwasserstoffrest allgemein auf einen Kohlenwasserstoffrest, der linear, verzweigt oder cyclisch sein kann. Bevorzugt sind lineare und verzweigte Kohlenwasserstoffreste.

Der mit L bezeichnete Ligand wird durch eine Struktur R²N-CR¹=NR³ gebildet. Formal betrachtet ist diese Struktur einfach negativ geladen. Die negative Ladung ist über die zwei Stickstoffatome mit den Resten R² und R³ und das mittlere Kohlenstoffatom mit dem Rest R¹ delokalisiert. Im Komplex der Formel (I) bildet L bevorzugt einen Elektronendonor.

Neben H und C₁ bis C₈ Kohlenwasserstoffrest kann R¹ auch ein Rest "-NR⁴R⁵" sein, d.h. eine Aminogruppe. R⁴ und R⁵ der Aminogruppe sind unabhängig voneinander entweder H oder ein C₁-C₈ Kohlenwasserstoffrest. Die Aminogruppe "-NR⁴R⁵" kann eine primäre Aminogruppe sein, wenn beide R⁴ und R⁵ H sind. Die Aminogruppe kann eine sekundäre Aminogruppe sein, wenn nur eines von R⁴ und R⁵ H ist. Die Aminogruppe kann eine tertiäre Aminogruppe sein, wenn keines von R⁴ und R⁵ H ist. Erfindungsgemäß ist es bevorzugt, dass R⁴ und R⁵ beide ein C₁-C₈ Kohlenwasserstoffrest sind, mehr bevorzugt sind beide ein C₁-C₆ Kohlenwasserstoffrest, noch mehr bevorzugt sind beide ein C₁-C₄ Kohlenwasserstoffrest. Erfindungsgemäß ist es insbesondere bevorzugt, dass R⁴ und R⁵ beide Methyl sind oder beide Ethyl sind, und mehr bevorzugt, dass beide Methyl sind.

Die Struktur R²N-CR¹=NR³ kann cyclische Gruppen aufweisen. Zum Beispiel können CR¹ und R²N zusammen Teil einer cyclischen Gruppe sein, wenn R¹ mit R² direkt verknüpft ist. Entsprechend können CR¹ und NR³ zusammen Teil einer cyclischen Gruppe sein, wenn R¹ mit R³ direkt verknüpft ist. Schließlich können R²N und NR³ zusammen Teil einer cyclischen Gruppe sein, wenn R² mit R³ direkt verknüpft ist. Direkt verknüpft meint dabei, dass an der jeweiligen Verknüpfung außer R¹, R² und R³ keine weiteren Atome oder Gruppen beteiligt sind.

Es ist erfindungsgemäß bevorzugt, dass in dem Rutheniumkomplex
- (aren): ein mit 1 bis 6 gleichen oder verschiedenen C₁-C₈ Kohlenwasserstoffresten substituiertes Aren oder ein Aren ist,
- R¹: aus H, C₁-C₈ Kohlenwasserstoffrest und -NR⁴R⁵ ausgewählt ist, wobei R⁴ und R⁵ unabhängig voneinander aus H und C₁-C₈ Kohlenwasserstoffresten ausgewählt sind, und
- R² und R³: unabhängig voneinander aus C₁-C₈ Kohlenwasserstoffresten ausgewählt sind.

In dem bevorzugten Rutheniumkomplex ist keiner der C₁-C₈ Kohlenwasserstoffreste substituiert. Dies kann zu einer Verbesserung der Flüchtigkeit und der Flüssigkeit bei Raumtemperatur führen.

In Fällen, in denen (aren) in dem bevorzugten Rutheniumkomplex ein substituiertes Aren ist, sind die Substituenten C₁-C₈ Kohlenwasserstoffreste, mehr bevorzugt C₁-C₆ Kohlenwasserstoffreste, noch mehr bevorzugt C₁-C₄ Kohlenwasserstoffreste. Das Aren weist in diesen Fällen bevorzugt 1 bis 6 Substituenten auf, also 1, 2, 3, 4, 5 oder 6 Substituenten, mehr bevorzugt 2 Substituenten.

Erfindungsgemäß ist es bevorzugt, dass der Ligand (aren) eine benzoide Struktur aufweist. Eine benzoide Struktur nennt man allgemein eine cyclische chemische Struktur, bei der formal noch drei Doppelbindungen innerhalb eines einzelnen sechsgliedrigen Kohlenstoff-Rings vorhanden sind. Im Rahmen der vorliegenden Erfindung weisen Benzol und ein mit 1 bis 6 C₁-C₈ Kohlenwasserstoffresten, bevorzugt mit 1 bis 6 C₁-C₆ Kohlenwasserstoffresten, mehr bevorzugt mit 1 bis 6 C₁-C₄ Kohlenwasserstoffresten substituiertes Benzol eine benzoide Struktur auf. Erfindungsgemäß ist es bevorzugt, dass der Ligand (aren) über eine solche benzoide Struktur an das Ruthenium koordiniert ist, und zwar über das delokalisierte π-Elektronensystem der benzoiden Struktur. In der für Komplexverbindungen üblichen *hapto*-Nomenklatur wird eine solche Koordination als η⁶-Koordination bezeichnet.

Erfindungsgemäß ist es bevorzugt, dass (aren) eine an Ru η⁶-koordinierte benzoide Struktur umfasst. Diese Koordination kann zu einer verbesserten Stabilität des Komplexes beitragen.

Erfindungsgemäß ist es bevorzugt, dass L über den Stickstoff von R²N und über den Stickstoff von NR³ an Ru koordiniert ist. Diese Koordination kann zu einer verbesserten Stabilität des Komplexes beitragen.

Erfindungsgemäß ist es bevorzugt, dass gleichzeitig (aren) eine an Ru η⁶-koordinierte benzoide Struktur umfasst und L über den Stickstoff von R²N und über den Stickstoff von NR³ an Ru koordiniert ist. Eine solche gleichzeitige Koordination ist in dem nachfolgenden allgemeinen Reaktionsschema gezeigt. Diese gleichzeitige Koordination kann zu einer verbesserten Stabilität des Komplexes beitragen.

Erfindungsgemäß ist es bevorzugt, dass in dem Rutheniumkomplex
- (aren): Benzol oder mit 1 bis 6 C₁-C₄ gleichen oder verschiedenen Kohlenwasserstoffresten substituiertes Benzol ist,
- X: H oder ein C₁-C₄ Kohlenwasserstoffrest ist,
- R¹: H, Methyl, Ethyl, -N(Methyl)₂ oder -N(Ethyl)₂ ist, und
- R², R³: jeweils ein C₁-C₄ Kohlenwasserstoffrest ist.

Ein solcher Rutheniumkomplex kann in wenigen Schritten unter milden Bedingungen darstellbar sein.

Erfindungsgemäß ist es bevorzugt, dass der Ligand (aren) im Rutheniumkomplex der allgemeinen Formel (I) ein mit Kohlenwasserstoffresten substituiertes Aren ist, insbesondere ein mit unterschiedlichen Kohlenwasserstoffresten substituiertes Aren. Erfindungsgemäß ist es dabei bevorzugt, dass (aren) mit zwei unterschiedlichen Kohlenwasserstoffresten substituiert ist. Ohne an diese Theorie gebunden zu sein wird davon ausgegangen, dass eine unterschiedliche bzw. unsymmetrische Substitution des Arens mit unterschiedlichen Kohlenwasserstoffresten, insbesondere mit zwei unterschiedlichen Kohlenwasserstoffresten wie beispielsweise in 4-Isopropyltoluol, eine Kristallisation des Rutheniumkomplexes erschwert. Die unsymmetrische Substitution des Arens kann somit zu einer Flüssigkeit des erfindungsgemäßen Rutheniumkomplexes bei Raumtemperatur beitragen.

Erfindungsgemäß ist es bevorzugt, dass (aren) aus Benzol und mit 1 bis 6 C₁-C₈ Kohlenwasserstoffresten substituiertem Benzol ausgewählt ist. Erfindungsgemäß ist es mehr bevorzugt, dass (aren) aus Benzol und mit 1 bis 6 C₁-C₆ Kohlenwasserstoffresten substituiertem Benzol ausgewählt ist. Erfindungsgemäß ist es noch mehr bevorzugt, dass (aren) aus Benzol und mit 1 bis 6 C₁-C₄ Kohlenwasserstoffresten substituiertem Benzol ausgewählt ist. Erfindungsgemäß ist es weiter bevorzugt, dass (aren) aus Benzol und 4-Isopropyltoluol ausgewählt ist. 4-Isopropyltoluol wird auch als p-Cymol oder para-Cymol bezeichnet. Benzol und substituiertes Benzol, insbesondere 4-Isopropyltoluol, als (aren) können stabile erfindungsgemäße Rutheniumkomplexe liefern.

Erfindungsgemäß ist es bevorzugt, dass der Ligand X aus H und einem C₁-C₆ Kohlenwasserstoffrest ausgewählt ist, mehr bevorzugt aus H und einem C₁-C₄ Kohlenwasserstoffrest. Erfindungsgemäß ist es insbesondere bevorzugt, dass der Ligand X aus Hydridoligand (H), Methyl (Me), Ethyl (Et), Propyl (Pr), Isopropyl (iPr) und tert-Butyl (tBu) ausgewählt ist. Mehr bevorzugt ist X aus H, Methyl und Ethyl ausgewählt. In einer bevorzugten Ausführungsform ist X H. In einer weiteren bevorzugten Ausführungsform ist X Methyl. In noch einer weiteren bevorzugten Ausführungsform ist X Ethyl. Je kleiner und leichter der Ligand X ist, umso flüchtiger und bei Raumtemperatur leichter flüssig können die entsprechenden Rutheniumkomplexe sein.

Erfindungsgemäß ist es bevorzugt, dass R¹ des Liganden L aus Methyl und -N(Methyl)₂ ausgewählt ist. Auf die Dimethylaminogruppe -N(Methyl)₂ wird im Rahmen der vorliegenden Erfindung teilweise auch als NMe₂ Bezug genommen. Methyl und -N(Methyl)₂ als R¹ können dazu beitragen, den Liganden L synthetisch leichter in Rutheniumkomplex-Zwischenstufen einzuführen.

Erfindungsgemäß sind R² und R³ unabhängig voneinander ausgewählt aus C₁-C₈ Kohlenwasserstoffresten, bevorzugt C₁-C₆ Kohlenwasserstoffresten, mehr bevorzugt C₁-C₄ Kohlenwasserstoffresten. Die Kohlenwasserstoffreste können optional substituiert sein, z.B. mit Aminogruppen. Erfindungsgemäß ist es bevorzugt, dass weder R² noch R³ Aminogruppen umfasst. Dies kann zu einer besseren Flüchtigkeit und Flüssigkeit bei Raumtemperatur führen.

Erfindungsgemäß ist es bevorzugt, dass R² und R³ unabhängig voneinander aus Methyl, Ethyl, Propyl, Isopropyl und tert-Butyl ausgewählt sind. Je kleiner und leichter die Reste R² und R³ sind, umso flüchtiger und bei Raumtemperatur leichter flüssig können die entsprechenden Rutheniumkomplexe sein.

Erfindungsgemäß kann es bevorzugt sein, dass R² und R³ gleich sind. Erfindungsgemäß kann es insbesondere bevorzugt sein, dass R² und R³ beide Isopropyl sind. Wenn R² und R³ gleich und insbesondere beide Isopropyl sind, kann der Ligand L besser als Metallorganyl in Rutheniumkomplex-Zwischenstufen eingeführt werden.

Erfindungsgemäß kann es bevorzugt sein, dass R² und R³ voneinander verschieden sind, z.B. ist R² Ethyl und ist R³ tert-Butyl. Daraus folgt eine unsymmetrische Struktur von L. Eine unsymmetrische Struktur von L kann dazu beitragen, eine Verfestigung des Rutheniumkomplexes bei Raumtemperatur zu verhindern.

Erfindungsgemäß kann es bevorzugt sein, dass R¹ nicht mit R², R¹ nicht mit R³ und R² nicht mit R³ direkt verknüpft ist, d.h. dass der Ligand L keine entsprechenden cyclischen Gruppen aufweist. Dies kann die Zahl der zur Synthese der erfindungsgemäßen Rutheniumkomplexe erforderlichen Schritte verkleinern.

Erfindungsgemäß kann es bevorzugt sein, dass R¹ und R² direkt miteinander verknüpft sind. Erfindungsgemäß kann es bevorzugt sein, dass R¹ und R³ direkt miteinander verknüpft sind. Erfindungsgemäß kann es bevorzugt sein, dass R² und R³ direkt miteinander verknüpft sind. Erfindungsgemäß kann es bevorzugt sein, dass sowohl R¹ und R² als auch R¹ und R³ direkt miteinander verknüpft sind, dass sowohl R¹ und R² als auch R² und R³ direkt miteinander verknüpft sind, dass sowohl R¹ und R³ als auch R² und R³ direkt miteinander verknüpft sind, und dass R¹ und R², R¹ und R³ sowie R² und R³ direkt miteinander verknüpft sind. Dies kann die Variabilität der Synthese der erfindungsgemäßen Rutheniumkomplexe vergrößern.

Erfindungsgemäß ist es bevorzugt, dass der Rutheniumkomplex unter Standardbedingungen flüssig ist. Standardbedingungen sind eine Temperatur von 25°C und ein absoluter Druck von 1•10⁵ Pa. Der Aggregatzustand "flüssig" schließt eine ölige Konsistenz des Rutheniumkomplexes ein. Flüssigkeit des Rutheniumkomplexes unter Standardbedingungen kann die Eignung des Rutheniumkomplexes für CVD- und ALD-Verfahren verbessern.

Erfindungsgemäß ist es bevorzugt, dass der Rutheniumkomplex nicht als Feststoff vorliegt. Erfindungsgemäß ist es insbesondere bevorzugt, dass der Rutheniumkomplex bei einem absoluten Druck von 1,013•10¹ Pa einen Schmelzpunkt von ≤ 25°C aufweist, mehr bevorzugt ≤ 10°C, weiter bevorzugt ≤ 0°C. Ein solcher Rutheniumkomplex kann für CVD- und ALD-Verfahren besser geeignet sein.

Ein erfindungsgemäßer Rutheniumkomplex kann nach Synthese in einem Lösungsmittel bevorzugt nicht durch Filtration und/oder Sublimation isoliert werden. Erfindungsgemäß ist es bevorzugt, dass ein erfindungsgemäßer Rutheniumkomplex durch Kondensation isolierbar ist. Erfindungsgemäß ist es insbesondere bevorzugt, dass der Rutheniumkomplex im Feinvakuum (FV) durch Kondensation isolierbar ist. Im Rahmen der vorliegenden Erfindung umfasst ein Feinvakuum einen Druckbereich von 10² bis 10⁴ Pa (0,001 bis 0,1 bar). Durch Kondensation isolierbare Rutheniumkomplexe können für eine Anwendung in CVD- und ALD-Verfahren besser geeignet sein.

Erfindungsgemäß ist es bevorzugt, dass der Rutheniumkomplex bei Temperaturen im Bereich von 100 bis 200°C, mehr bevorzugt im Bereich von 100 bis 150 °C oder im Bereich von 150 bis 200°C, zerfällt. Ein Zerfallen des Rutheniumkomplexes bei diesen Temperaturen kann die Eignung des Rutheniumkomplexes für CVD- und ALD-Verfahren verbessern.

Erfindungsgemäß ist es bevorzugt, dass ein Einsetzen eines Zerfalls eines erfindungsgemäßen Rutheniumkomplexes durch thermische Analyse bestimmt wird. Die thermische Analyse ist bevorzugt eine thermogravimetrische Analyse (TGA). Die thermogravimetrische Analyse ist eine analytische Methode, bei der Masseänderungen einer Probe in Abhängigkeit von Temperatur und Zeit gemessen werden. Bei der thermogravimetrischen Analyse wird die Probe in einem Tiegel erhitzt. Eine Halterung des Tiegels ist an eine Waage gekoppelt, welche Masseänderungen während des Aufheizvorgangs registriert. Kommt es beim Aufheizvorgang zu einem Masseabbau, kann dies den Zerfall der Probe anzeigen.

Erfindungsgemäß ist es bevorzugt, dass die Temperatur eines einsetzenden Masseabbaus durch zersetzungsfreie Verdampfung, gemessen in einer thermogravimetrischen Analyse (TGA) bei 1•10⁵ Pa (1 bar), mindestens 10 bis 30°C unterhalb des Zersetzungspunktes liegt. Die TGA erfolgt typischerweise in einem Temperaturbereich von 25°C bis 600°C oder 25°C bis 700°C. Die Aufheizgeschwindigkeit bei der TGA beträgt typischerweise 10°C/min. Der Masseabbau, bedingt durch Verdampfung und/oder Zersetzung, wird bevorzugt über TGA und über eine simultane Differenz-Thermoanalyse (SDTA) verfolgt. Die SDTA bestimmt den Wärmefluss anhand von endothermen Peaks (z.B. Schmelzpunkt, Verdampfung aus der flüssigen Phase, Sublimation unterhalb des Schmelzpunktes) bzw. von exothermen Peaks (z.B. exotherme Zersetzungsreaktion). Ein endothermer Peak ohne Masseverlust entspricht regelmäßig einem Schmelzpunkt. Ein endothermer Peak mit Masseverlust entspricht einer Verdampfung. Ein exothermer Peak mit Masseverlust entspricht einer Zersetzung. Über Onset-Werte lassen sich diese Kenngrößen experimentell bestimmen. Angegeben wird die Temperatur einer TGA/SDTA, bei der die Masse der untersuchten Probe des Rutheniumkomplexes um 3 Gew.-% abgebaut ist (3% Abbau). Erfindungsgemäß ist es bevorzugt, dass in einer thermogravimetrischen Analyse die Temperatur dieses ersten Masseabbaus von 3 Gew.-% des Rutheniumkomplexes bei 1•10⁵ Pa im Bereich von 80 bis 200°C liegt, mehr bevorzugt im Bereich von 80 bis 150°C.

Gegenstand der Erfindung ist auch ein Verfahren zur Herstellung eines erfindungsgemäßen Rutheniumkomplexes, wobei das Verfahren die folgenden Schritte umfasst:
(i) Umsetzen einer Verbindung mit der Formel R²N=C=NR³ mit einer Verbindung mit der Formel Li-R¹ zur Herstellung einer Verbindung mit der Formel Li(R²N-CR¹=NR³),
(ii) Umsetzen der Verbindung Li(R²N-CR¹=NR³) mit einer Verbindung mit der Formel [RuCl₂(aren)]₂ zur Herstellung einer Verbindung mit der Formel [(aren)RuCl(R²N-CR¹=NR³)], und
(iii) Umsetzen der Verbindung [(aren)RuCl(R²N-CR¹=NR³)] mit einer Verbindung MXₙ, wobei M = Metall und n = 1, 2, 3 oder 4 ist.

Bei dem erfindungsgemäßen Verfahren erfolgen die Schritte (i), (ii) und (iii) in der angegebenen Reihenfolge. Dabei ist es insbesondere bevorzugt, dass die Verbindung Li(R²N-CR¹=NR³) *in situ* gebildet und direkt mit einer Verbindung mit der Formel [RuCl₂(aren)]₂ umgesetzt wird. Anders ausgedrückt wird die Verbindung Li(R²N-CR¹=NR³) vor dem Umsetzen mit der Verbindung [RuCl₂(aren)]₂ nicht isoliert.

Es ist erfindungsgemäß bevorzugt, dass MXₙ aus LiAlH₄, MeLi oder EtMgBr ausgewählt ist.

Gegenstand der Erfindung ist auch eine Verwendung eines erfindungsgemäßen Rutheniumkomplexes zur Abscheidung von Ruthenium in einem CVD-Verfahren oder einem ALD-Verfahren.

Gegenstand der Erfindung ist auch ein Verfahren, in dem ein erfindungsgemäßer Rutheniumkomplex als Präkursor zur Herstellung einer Rutheniumschicht verwendet wird.

Gegenstand der Erfindung ist auch eine ruthenierte Oberfläche, die durch Abscheiden von Ruthenium auf einer Oberfläche aus einer Gasphase erhältlich ist. Die Gasphase umfasst dabei einen erfindungsgemäßen Rutheniumkomplex.

### Allgemeines Syntheseschema

Die Synthese eines erfindungsgemäßen Rutheniumkomplexes kann über die jeweilige Ruthenium-Chlorido-Verbindung [(Aren)RuCIL] gefolgt durch Substitution von Cl durch eine Alkylgruppe wie z.B. Me, Et oder einen Hydridoliganden H erfolgen.

Die Darstellung der Chlorido-Zwischenstufen gelingt z.B. in einer Eintopfsynthese aus dem Lithiumsalz eines Guanidinats, vorzugsweise *in situ* gebildet über Addition eines sekundären Lithiumamids wie LiNMe₂ an ein Carbodiimid R²N=C=NR³ (R², R³ = iPr oder andere, auch unterschiedliche Alkylgruppe) und Umsetzung der Reaktionslösung mit Verbindungen des Typs [RuCl₂(aren)]₂. Für Amidinate gelingt die Eintopfsynthese aus dem Lithiumsalz des Amidinats, ggf. *in situ* gebildet über Addition eines Lithiumorganyls LiR¹ (bevorzugt R¹ = Me), an ein Carbodiimid R²N=C=NR³ (R², R³ = iPr oder andere Alkylgruppe) und Umsetzung dieser Reaktionslösung mit Verbindungen des Typs [RuCl₂(aren)]₂. Die nachfolgende Substitution von Cl wird ohne großen synthetischen Aufwand durch Umsetzung mit z.B. LiAlH₄, MeLi oder EtMgBr erzielt. Eine Eintopfsynthese ausgehend von [RuCl₂(aren)]₂ ohne notwendige Isolierung des Chlorido-Zwischenproduktes ist bei Verwendung von Lösungen der Reaktanden exakt bekannten Gehaltes möglich.

Mögliche Synthesewege für erfindungsgemäße Rutheniumkomplexe sind in dem nachfolgenden allgemeinen Reaktionsschema zusammengefasst:

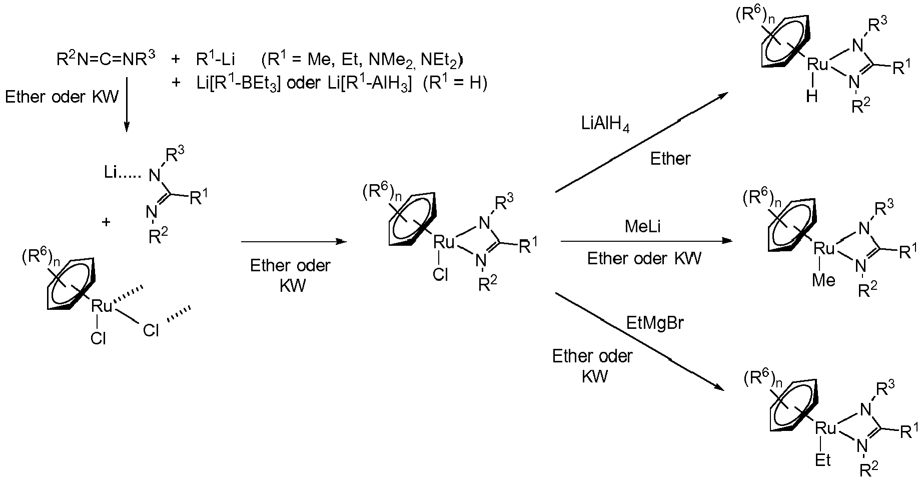

In dem Reaktionsschema sind die Reste R¹, R², R³ und R⁶ wie hierin beschrieben.

Die Reaktionsschritte in dem Schema können in Ethern, vorzugsweise Diethylether (Et₂O) oder Tetrahydrofuran (THF), ggf. auch im Gemisch mit Kohlenwasserstoffen (KW) wie Hexan oder Toluol, jeweils bei 0°C durchgeführt werden. Die Chlorido-Komplexe können nach Entfernen des Lösungsmittels im Vakuum mit *n*Hexan extrahiert und durch Sublimation in Reinstform erhalten werden. Die Isolierung des Zwischenproduktes ist aber nicht zwingend notwendig, da auch ein Lösungsmittelwechsel für den letzten Schritt nicht zwingend notwendig ist.

Die beispielhafte Substitution des Chlorido-Liganden am Ruthenium verläuft mit einem Grignard-Reagenz für die Einführung der Ethyl-Gruppe, mit MeLi für die Einführung der Methyl-Gruppe und mit LiAlH₄ für die Einführung des Hydrids. Denkbar ist auch der Einsatz von Red-Al® (Na[H₂Al(OCH₂CH₂OMe)₂]), LiBH₄ und Li[HBEt₃] zur Darstellung der Hydrid-Zielverbindungen. Die Substitutionen des Chloridoliganden werden vorteilhaft bei 0°C durchgeführt und liefern nach Aufarbeitung (z.B. Extraktion mit nHexan, Filtration über CELITE®), Abdampfen des Lösungsmittels, und ggf. Reinigung durch Kondensation, typischerweise gelbliche flüchtige Öle.

### Anwendungen für die erfindungsgemäßen Komplexe

Die erfindungsgemäßen Rutheniumkomplexe finden Verwendung als Präkursoren für Ruthenium bzw. Rutheniumschichten. Insbesondere können sie zur Herstellung von Dünnschichten aus Ruthenium mittels Gasphasen-Dünnschichtverfahren wie CVD und ALD dienen.

Die chemische Gasphasenabscheidung (CVD) ist eine Gasphasenreaktion, die in der Regel an oder in der Nähe einer Oberfläche eines Substrats abläuft. Dabei werden an der Reaktion beteiligte Reaktanten bzw. Präkursoren in Form von Gasen dem zu beschichtenden Substrat zugeleitet. Das Substrat ist dabei in einer Reaktionskammer angeordnet und wird beheizt. Die meist vorgeheizten Gase werden durch das beheizte Substrat thermisch aktiviert und reagieren miteinander bzw. dem Substrat. In den Gasen enthaltene Präkursoren werden durch das beheizte Substrate thermisch zersetzt. Dadurch wird das erwünschte Material abgeschieden und chemisch gebunden. Es kommt zu einer Chemisorption des erwünschten Materials, in der vorliegenden Erfindung des Rutheniums.

Das ALD-Verfahren, auch als Atomlagenabscheidung bezeichnet, ist ein verändertes CVD-Verfahren. Beim ALD-Verfahren endet die Reaktion bzw. Sorption an der Oberfläche nach der vollständigen Belegung der Oberfläche von sich aus. Diese selbstbegrenzende Reaktion wird in mehreren Zyklen durchlaufen, die von dazwischenliegenden Spülschritten begrenzt werden. Auf diese Weise werden sehr exakte Schichtdicken erreicht.

Wie oben beschrieben sind die erfindungsgemäßen Rutheniumkomplexe durch eine wenig aufwändige technische Synthese darstellbar. Die einfache technische Synthese ist ein wichtiger Vorteil bei einer industriellen Anwendung der erfindungsgemäßen Rutheniumkomplexe in Prozessen der Gasphasenabscheidung. Ein weiterer wichtiger Grund für die besondere Eignung der erfindungsgemäßen Rutheniumkomplexe für CVD- und/oder ALD-Verfahren liegt darin, dass die erfindungsgemäßen Rutheniumkomplexe flüchtige, teils bei Raumtemperatur flüssige Verbindungen sind. Zudem lassen sie sich erfolgreich zu elementarem Ruthenium zersetzen. Sie stellen damit für die Abscheidung von elementarem Ruthenium eine vorteilhafte Alternative zu bekannten Ruthenium-Präkursoren dar.

Dies wird auch durch die nachfolgenden Beispiele belegt, insbesondere durch die Ergebnisse der in diesem Zusammenhang durchgeführten thermogravimetrischen und pulverdiffraktometrischen Untersuchungen. Die Untersuchungen mittels TGA/SDTA zeigen zunächst für einige der Verbindungen, dass diese bei 25°C flüssig sind und keinen Schmelzpunkt oberhalb von 25°C aufweisen. Darüber hinaus wird deutlich, dass Verbindungen mit X = Me und H bei Drücken von 1•10⁵ Pa oder niedriger unzersetzt verdampfbar sein können. Ferner ist eine Zersetzung solcher Verbindungen bei unter 200 °C möglich. Röntgenpulverdiffrakometrie (RPD) ermöglicht, den Rückstand im Tiegel nach der Zersetzung bei der thermogravimetrischen Analyse auf mikrokristalline Phasen im Pulver zu untersuchen. Ein beobachtetes, erfindungsgemäßes Ergebnis ist der Nachweis der Bildung einer bekannten Phase von elementarem Ruthenium. Die Phase wird durch einen Vergleich des experimentell gefundenen Musters an Reflexwinkeln mit den Daten für Ruthenium aus einer Reflexwinkel-Datenbank nachgewiesen. Die Bildung einer bekannten Phase von elementarem Ruthenium kann auf eine besondere Eignung für CVD- und/oder ALD-Verfahren hinweisen.

### usführungsbeispiele

In den nachfolgenden Beispielen bedeutet:
- bima: N,N'-Bis(isopropylamino)acetamidinat
- bidmg: N,N'-Bis(isopropylamino)-N"-dimethylguanidinat
- dmfa: N,N'-Dimethylformamidinat

### Beispiel 1 (Referenz) - Darstellung und Charakterisierung von Li(bima)[1]

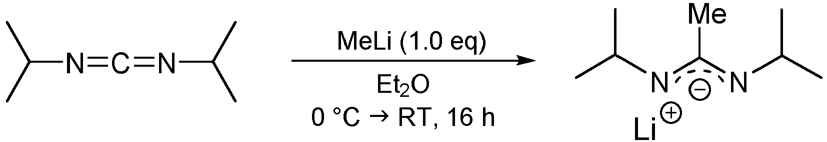

*N*,*N*-Di-*iso*-propylcarbodiimid (4.20 g, 33.3 mmol, 1.0 eq) wurde in Et₂O (50.0 mL) vorgelegt und bei 0 °C tropfenweise mit MeLi (in Et₂O, 1.60 mL, 33.3 mmol, 1.0 eq) versetzt. Das Reaktionsgemisch wurde für 16 Stunden gerührt, wobei es Raumtemperatur erreichen konnte. Nach Entfernen aller flüchtigen Bestandteile im Feinvakuum wurde der Rückstand mit *n*Hexan (2 20 mL) gewaschen und im Feinvakuum getrocknet. Li(bima) wurde als farbloser Feststoff (3.62 g, 24.3 mmol, 73%) erhalten.
- ¹H-NMR: (THF-*d*₈, 300.2 MHz): *δ* / ppm = 3.42 (sept, 2 H, *ⁱ*Pr), 1.75 (s, 3 H, Me), 0.96 (d, ³*J*_{HH} = 6.2 Hz, 12 H, *ⁱ*Pr).
- ¹³C-NMR: (THF-*d*₈, 75.5 MHz): *δ* / ppm = 168.6 (C_{q}), 47.6 (*ⁱ*Pr), 27.3 (*ⁱ*Pr), 10.4 (Me).
- Elementaranalyse: C₈H₁₇N₂Li (148.18 g/mol) berechnet: C: 64.85%, H: 11.56%, N: 18.91% gefunden: C: 63.20%, H: 11.21%, N: 18.46%.
- IR: (Substanz) *ṽ*/cm⁻¹ = 2958 (m), 2926 (m), 2861 (m), 1484 (vs), 1416 (s), 1373 (m), 1356 (m), 1332 (s), 1311 (s), 1170 (m), 1123 (m), 1047 (w), 1013 (m), 975 (w), 940 (w), 822 (w), 790 (w), 611 (w), 501 (m), 443 (w).

### Beispiel 2 (Referenz) - Darstellung und Charakterisierung von [RuCl(p-cymol)(bidmg)]

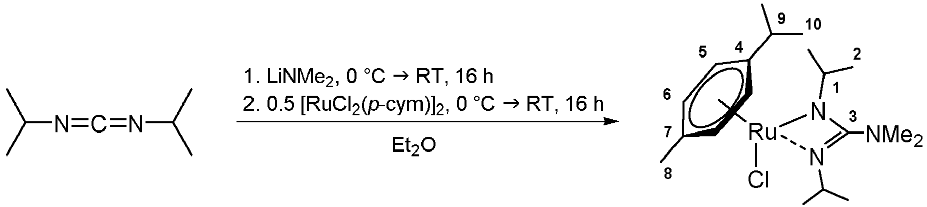

LiNMe₂ (83.1 mg, 1.63 mmol, 2.00 eq) wurde in THF (80 mL) vorgelegt und bei 0 °C mit *N*,*N*-Diisopropylcarbodiimid (206 mg, 1.63 mmol, 2.00 eq) versetzt. Das Gemisch wurde für 16 Stunden gerührt, wobei es sich auf Raumtemperatur erwärmen konnte. Zu der klaren, farblosen Lösung wurde [Ru(*p*-cymol)Cl₂]₂ (500 mg, 0.82 mmol, 1.00 eq) gegeben und erneut für 16 Stunden gerührt. Nach Entfernen aller flüchtigen Bestandteile im Vakuum wurde der Rückstand in *n*Hexan (50 mL) aufgenommen und über CELITE® filtriert. Der Filterkuchen wurde mit weiteren Mengen an *n*Hexan (30 mL) extrahiert und das Filtrat im Vakuum vom Lösungsmittel befreit. Das gelb-orangefarbene, kristalline Produkt (6.25 g, 14.2 mmol, 91%) konnte ferner durch Sublimation (FV/70 °C) weiter aufgereinigt werden, worüber die Zielverbindung letztlich als gelb-orangefarbener Feststoff (1.92 g, 4.36 mmol, 28%) isoliert werden konnte.
- ¹H-NMR: C₆D₆, 300.2 MHz: *δ* / ppm = 4.99 (d, ³*J*_{HH} = 5.8 Hz, 2 H, H-5), 4.77 (d, ³*J*_{HH} = 5.8 Hz, 2 H, H-6), 3.61 (sept, 2 H, H-1), 2.60 (sept, 1 H, H- 9), 2.45 (s, 6 H, NMe₂), 2.07 (s, 3 H, H-8), 1.43 (d, ³*J*_{HH} = 6.6 Hz, 6 H, *ⁱ*Pr), 1.26 (d, ³*J*_{HH} = 6.3 Hz, 6 H, *ⁱ*Pr), 1.06 (d, ³*J*_{HH} = 7.3 Hz, 6 H, *ⁱ*Pr).
- ¹³C-NMR: C₆D₆, 75.5 MHz: *δ* / ppm = 166.8 (C-3), 97.9 (C-4), 97.7 (C-7), 79.1 (C-6), 79.0 (C-5), 47.5 (C-1), 40.6 (NMe₂), 32.5 (C-10), 26.7 (C-2), 25.6 (C-2), 22.7 (C-8), 19.4 (C-9).
- HR-EI(+)-MS: Berechnet für [M+H]⁺ = 441.1485 m/z, gefunden: 441.1488 m/z.
- Elementaranalyse: C₁₉H₃₄N₃ClRu (441.02 g/mol) berechnet: C: 51.75%, H: 7.77%, N: 9.53% gefunden: C: 51.93%, H: 7.85%, N: 10.13%.
- IR: (Substanz) *ṽ*/cm⁻¹ = 2956 (s), 2919 (m), 2861 (m), 2789 (w). 1610 (w), 1494 (vs), 1448 (s), 1419 (m), 1371 (m), 1357 (m), 1321 (s), 1199 (s), 1165 (m), 1141 (m), 1115 (w), 1091 (s), 1057 (w), 1004 (w), 973 (m), 933 (m), 849 (w), 802 (w), 753 (w), 706 (w), 667 (w), 544 (w), 446 (w).
- TGA: (T_{S} = 25 °C, T_{E} = 700 °C, 10 °C/min, m = 9.40 mg) Stufen: 1, T= 155.1 °C (3% Abbau), T= 183.6 °C, (max. Abbaugeschwindigkeit), Gesamtmasseabbau: 4.83 mg (51.4%).
- SDTA: (T_{S}= 25 °C, T_{E} = 700 °C, 10 °C/min, m = 9.40 mg) T_{M}(Onset) = 77.0 °C, T_{M}(max) = 81.0 °C (endotherm), T_{D}(Onset) = 174.4 °C, T_{D}(max.) = 182.9 °C (exotherm).

### Beispiel 3 - Darstellung und Charakterisierung von [RuMe(p-cymol)(bidmq)]

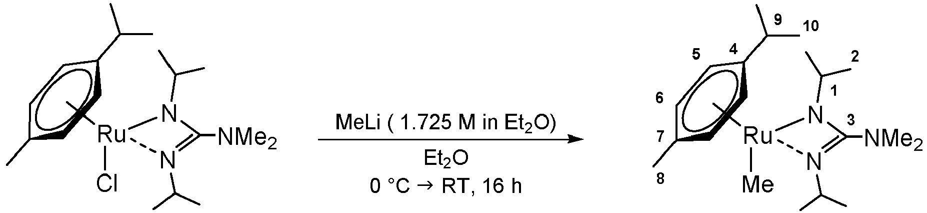

[RuC(*p*-cymol)(bidmg)] (300 mg, 0.68 mmol, 1.00 eq) wurde bei 0 °C in Et₂O (20 mL) gelöst und mit einer Methyllithium-Lösung (1.725 M in Et₂O, 1.17 mL, 0.68 mmol, 1.0 eq) in Et₂O (5 mL) hinzugegeben. Das Gemisch wurde für 16 Stunden gerührt, wobei es sich langsam auf Raumtemperatur erwärmen konnte. Die flüchtigen Bestandteile der klaren, hellgelben Lösung wurden daraufhin im Vakuum entfernt, der Rückstand in *n*Hexan (10 mL) aufgenommen und über einen Spritzenfilter filtriert. Das Filtrat wurde im Vakuum vom Lösungsmittel befreit und das gelartige Rohprodukt umkondensiert (FV/45 °C). Die Zielverbindung konnte als gelb-orangefarbene viskose Flüssigkeit (120 mg, 0.29 mmol, 43%) isoliert werden.
- ¹H-NMR: C₆D₆, 300.2 MHz: *δ* / ppm = 4.90 (d, ³*J*_{HH} = 5.5 Hz, 2 H, H-5), 4.26 (d, ³*J*_{HH} = 5.7 Hz, 2 H, H-6), 3.67 (sept, 2 H, H-1), 2.65 (sept, 2 H, H-9), 2.50 (s, 6 H, NMe₂), 2.02 (s, 3 H, H-8), 1.21 (d, ³*J*_{HH} = 7.1 Hz, 6 H, *ⁱ*Pr), 1.16 (d, ³*J*_{HH} = 6.3 Hz, 6 H, *ⁱ*Pr), 0.97 (d, ³*J*_{HH} = 6.5 Hz, 6 H, *ⁱ*Pr), 0.89 (s, 3 H, RuMe).
- ¹³C-NMR: C₆D₆, 75.5 MHz: δ / ppm = 160.2 (C-3), 106.8 (C-4), 95.8 (C-7), 81.0 (C-6), 73.2 (C-5), 46.8 (C-1), 41.1 (NMe₂), 32.9 (C-10), 26.2 (C-2), 25.0 (C-2), 23.7 (C-8), 18.7 (C-9), 6.73 (RuMe).
- HR-EI(+)-MS: Berechnet für [M+H]⁺ = 421.2031 m/z, gefunden: 421.2017 m/z.
- Elementaranalyse: C₂₀H₃₇N₃Ru (420.61 g/mol)
berechnet: C: 57.11%, H: 8.87%, N: 9.99%
gefunden: C: 57.07%, H: 8.75%, N: 10.79%.
Aufgrund des flüssigen Aggregatzustandes der Verbindung mussten die Proben für die Elementaranalyse in zusätzlichen Übertiegeln eingeschlossen werden, was zum Einschluss von mehr Stickstoff und folglich zur Verfälschung dieses Messwertes führt.
- IR: (Substanz) *ṽ*/cm⁻¹ = 3051 (m), 2959 (m), 2924 (m), 2787 (w), 1504 (vs), 1447 (s), 1417 (m), 1373 (m), 1354 (m), 1328 (s), 1280 (w), 1203 (s), 1163 (s), 1145 (s), 1116 (m), 1084 (w), 1055 (s), 1004 (w), 969 (m), 835 (m), 802 (m), 655 (w), 540 (w), 503 (w), 446 (w).
- TGA: (T_{S} = 25 °C, T_{E} = 600 °c, 10 °C/min, m = 10.0 mg) Stufen: 1, T = 166.7 °C (3% Abbau), T= 198.9 °C, (max. Abbaugeschwindigkeit), Gesamtmasseabbau: 5.92 mg (59.2%).
- SDTA: (T_{S} = 25 °C, T_{E} = 600 °C, 10 °C/min, m = 9.40 mg) T_{D}(Onset) = 160.4 °C, T_{D}(max.) = 196.1 °C (exotherm).

### Beispiel 4 - Darstellung und Charakterisierung von [RuH(p-cymol)(bidmg)]

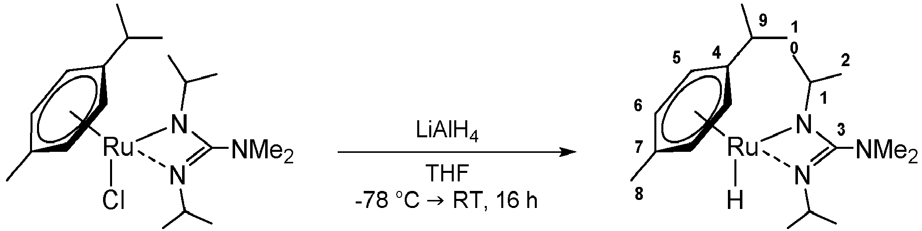

[RuCl(*p*-cymol)(bidmg)] (0.40 g, 0.91 mmol, 1.00 eq) und LiAlH₄ (10.0 mg, 0.27 mmol, 0.30 eq) wurden zusammen vorgelegt und in THF (20 mL) bei -78 °C suspendiert. Das Gemisch wurde für 16 Stunden gerührt, wobei es sich langsam auf Raumtemperatur erwärmen konnte. Die flüchtigen Bestandteile wurden im Vakuum entfernt, der Rückstand in *n*Hexan (10 mL) aufgenommen und über CELITE® filtriert. Das Filtrat wurde im Vakuum vom Lösungsmittel befreit und die Zielverbindung aus dem Rückstand herauskondensiert (FV/45 °C), wobei [RuH(*p*-cymol)(bidmg)] als intensiv gelbe Flüssigkeit (0.17 g, 0.42 mmol, 46%) isoliert werden konnte.
- ¹H-NMR: C₆D₆, 300.2 MHz: δ / ppm = 4.83 (d, ³J_{HH} = 5.0 Hz, 2 H, H-5), 4.73 (d, ³J_{HH} = 5.3 Hz, 2 H, H-6), 3.52 (sept, 2 H, H-1), 2.61 (sept, 2 H, H- 9), 2.41 (s, 6 H, NMe₂), 2.20 (s, 3 H, H-8), 1.32 (d, ³J_{HH} = 7.1 Hz, 6 H, ⁱPr), 1.16 (d, ³J_{HH} = 6.1 Hz, 6 H, ⁱPr), 1.01 (d, ³J_{HH} = 6.6 Hz, 6 H, ⁱPr), -4.66 (s, 1 H, RuH).
- ¹³C-NMR: C₆D₆, 75.5 MHz: δ / ppm = 160.1 (C-3), 105.7 (C-4), 96.7 (C-7), 77.0 (C-6), 76.2 (C-5), 46.2 (C-1), 40.2 (NMe₂), 33.4 (C-10), 26.5 (C-2), 25.6 (C-2), 24.2 (C-8), 21.2 (C-9).
- HR-EI(+)-MS: Berechnet für [M+H]⁺ = 407.1875 m/z, gefunden: 407.1888 m/z.
- Elementaranalyse: C₁₉H₃₅N₃Ru (406.56 g/mol)
berechnet: C: 56.13%, H: 8.68%, N: 10.34%
gefunden: C: 56.36%, H: 8.67%, N: 11.23%.
Aufgrund des flüssigen Aggregatzustandes der Verbindung mussten die Proben für die Elementaranalyse in zusätzlichen Übertiegeln eingeschlossen werden, was zum Einschluss von mehr Stickstoff und folglich zur Verfälschung dieses Messwertes führt.
- IR: (Substanz) *ṽ*/1cm⁻¹ = 3052 (w), 2959 (vs), 2918 (s), 2864 (s), 2788 (m), 1884 (m), 1638 (w), 1493 (vs), 1445 (s), 1411 (s), 1371 (m), 1352 (m), 1329 (m), 1282 (w), 1198 (s), 1166 (m), 1142 (m), 1117 (m), 1083 (w), 1054 (vs), 1004 (w), 971 (m), 834 (s), 803 (m), 677 (m), 539 (m), 444(w).
- TGA: (T_{S} = 25 °C, T_{E} = 600 °C, 10 °C/min, m = 15.1 mg) Stufen: 1, T = 119.5 °C (3% Abbau), T= 167.6 °C, (max. Abbaugeschwindigkeit), Gesamtmasseabbau: 7.55 mg (50.0%).
- SDTA: (T_{S} = 25 °C, T_{E} = 600 °C, 10 °C/min, m = 15.1 mg) T_{D}(Onset) = 161.0 °C, T_{D}(max.) = 169.7 °C (exotherm).

### Beispiel 5 (Referenz) - Darstellung und Charakterisierung von [RuCl(p-cymol)(bima)]^{[2]}

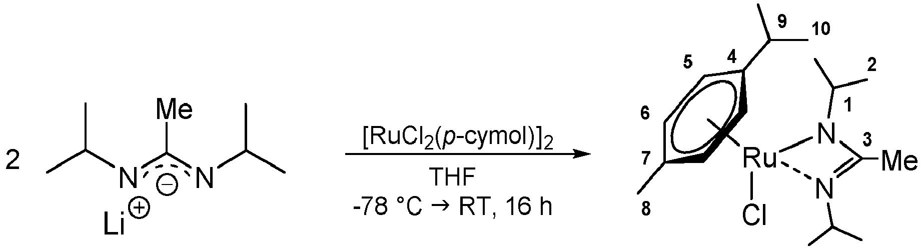

Li(bima) (403 mg, 2.70 mmol, 2.3 eq) wurde in THF (20.0 mL) vorgelegt und bei -78 °C mit [RuCl₂(*p*-cymol)]₂ (735 mg, 1.20 mmol, 1.0 eq) versetzt. Das Gemisch wurde für 16 Stunden gerührt, wobei es Raumtemperatur erreichte und eine Färbung ins Dunkelrote einging. Nach Entfernen aller flüchtigen Bestandteile im Feinvakuum wurde der Rückstand in *n*Hexan (20 mL) suspendiert und über CELITE® filtriert. Der Filterkuchen wurde dabei mit weiteren Mengen an *n*Hexan (30 mL) extrahiert und das erhaltene Filtrat anschließend im Feinvakuum eingetrocknet. Mittels Sublimation (FV/120 °C) wurde [RuCl(*p*-cymol)(bima)] als dunkelroter Feststoff (149 mg, 0.45 mmol, 29%) erhalten.
- ¹H-NMR: (C₆D₆, 300.2 MHz): 4.97 (d, ³*J*_{HH} = 5.9 Hz, 2 H, H-5), 4.70 (d, ³*J*_{HH} = 5.9 Hz, 2 H, H-6), 3.32 (sept, 2 H, H-1), 2.64 (sept, 1 H, H-9), 2.06 (s, 3 H, H-8), 1.38 (d, ³*J*_{HH} = 5.7 Hz, 6 H, *ⁱ*Pr), 1.38 (s, 3 H, Me), 1.18 (d, ³*J*_{HH} = 6.7 Hz, 6 H, *ⁱ*Pr), 1.10 (d, ³*J*_{HH} = 6.8 Hz, 6 H, *ⁱ*Pr).
- ¹³C-NMR: (C₆D₆,75.5 MHz): *δ* / ppm = 173.5 (C-3), 98.4 (C-4), 97.6 (C-7), 79.2 (C-6), 78.6 (C-5), 48.0 (C-1), 32.4 (Me), 26.2 (C-10), 25.9 (C-2), 22.8 (C-2), 19.3 (C-8), 13.5 (C-9).
- HR-EI(+)-MS: berechnet für: [M]⁺ = 412.1220 m/z, gefunden: 441.1219 m/z.
- Elementaranalyse: C₁₈H₃₁N₂ClRu (406.56 g/mol)
berechnet: C: 52.48%, H: 7.58%, N: 6.80%
gefunden: C: 52.32%, H: 7.39%, N: 6.50%.
- IR: (Substanz) *ṽ*/cm⁻¹ = 2955 (s), 2922 (m), 2861 (m), 2593 (w), 1507 (s), 1468 (m), 1447 (m), 1422 (m), 1373 (m), 1358 (m), 1331 (vs), 1310 (m), 1275 (m), 1213 (s), 1169 (m), 1143 (m), 1119 (m), 1089 (m), 1054 (m), 1012 (m), 928 (w), 885 (w), 847 (m), 803 (m), 732 (w), 703 (w), 662 (w), 630 (w), 577 (w), 548 (w), 521 (w), 483 (w), 445 (w).
- TGA: (Ts=25 °C, T_{E} = 700 °C, 10 °C/min, m = 9.75 mg) Stufen: 1, T = 179.3 °C (3% Abbau), T_{MA} = 205.8 °C (1. Prozess), T_{MA} = 292.5 °C (2. Prozess), Gesamtmasseabbau: 7.32 mg (75.0%).
- SDTA: (T_{S}= 25 °C, T_{E} = 700 °C, 10 °C/min, m = 9.75 mg) T_{M}(Onset) = 61.0 °C, T_{M}(max) = 65.0 °C (endotherm), T_{D1}(Onset) = 186.3 °C, T_{D1}(max) = 189.2 °C (endotherm), T_{D2}(Onset) = 202.1 °C, T_{D2}(max) = 210.0 °C (exotherm).

### Beispiel 6 - Darstellung und Charakterisierung von [RuMe(p-cymol)(bima)]

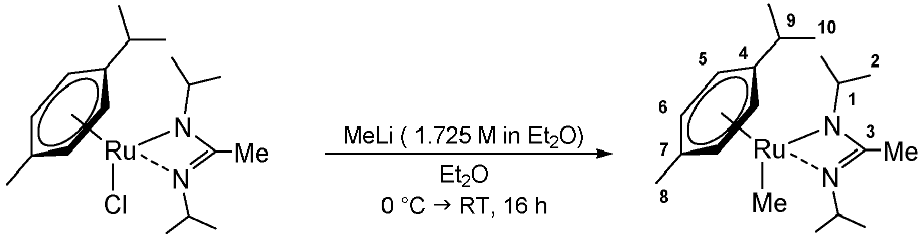

[RuCl(p-cymol)(bima)] (632 mg, 1.53 mmol, 1.0 eq) wurde in Et₂O (20 mL) vorgelegt und bei 0 °C mit MeLi (1.725 M in Et₂O, 0.96 mL, 1.53 mmol, 1.0 eq) versetzt. Das Gemisch wurde für 16 Stunden gerührt, wobei es Raumtemperatur erreichen konnte und anschließend über CELITE® filtriert. Der Filterkuchen wurde mit weiteren Mengen an Et₂O (15 mL) extrahiert und das Filtrat im Feinvakuum von allen flüchtigen Bestandteilen befreit. Mittels Kondensation (FV/110 °C) konnte [RuMe(p-cymol)(bima)] aus dem Rückstand als gelbes ÖI (216 mg, 0.55 mmol, 36%) isoliert werden.
- ¹H-NMR: (C₆D₆, 300.2 MHz): 4.85 (d, ³J_{HH} = 5.7 Hz, 2 H, H-5), 4.21 (d, ³J_{HH} = 5.7 Hz, 2 H, H-6), 3.37 (sept, 2 H, H-1), 2.70 (sept, 1 H, H-9), 2.04 (s, 3 H, Me), 1.42 (s, 3 H, H-8), 1.23 (d, ³J_{HH} = 7.2 Hz, 6 H, ⁱPr), 1.11 (d, ³J_{HH} = 6.5 Hz, 6 H, ⁱPr), 1.05 (s, 3 H, RuMe), 0.91 (d, ³J_{HH} = 6.5 Hz, 6 H, ⁱPr).
- ¹³C-NMR: (C₆D₆, 75.5 MHz): δ / ppm = 164.7 (C-3), 106.8 (C-4), 96.7 (C-7), 80.7 (C-6), 72.9 (C-5), 47.5 (C-1), 32.7 (Me), 26.1 (C-10), 25.2 (C-2), 23.8 (C-2), 18.7 (C-8), 12.2 (C-9), 5.39 (RuMe).
- HR-EI(+)-MS: berechnet für: [M]⁺ = 392.1766 m/z, gefunden: 392.1751 m/z.
- Elementaranalyse: C₁₉H₃₄N₂Ru (391.57 g/mol)
berechnet: C: 58.28%, H: 8.75%, N: 7.15%
gefunden: C: 57.59%, H: 8.67%, N: 11.30%.
Aufgrund des flüssigen Aggregatzustandes der Verbindung mussten die Proben für die Elementaranalyse in zusätzlichen Übertiegeln eingeschlossen werden, was zum Einschluss von mehr Stickstoff und folglich zur Verfälschung dieses Messwertes führt.
- IR: *ṽ*/cm⁻¹ = 3052 (w), 2958 (vs), 2924 (s), 2865 (s), 2791 (w), 2594 (w), 1651 (w), 1521 (vs), 1447 (m), 1373 (m), 1356 (m), 1329 (s), 1274 (w), 1217 (s), 1168 (m), 1145 (m), 1116 (m), 1083 (w), 1054 (m), 1012 (m), 921 (w), 886 (w), 836 (m), 803 (w), 655 (w), 628 (w), 567 (w), 545 (w), 501 (w), 443 (w), 420 (w).
- TGA: (Ts = 25 °C, T_{E} = 600 °C, 10 °C/min, m = 8.48 mg) Stufen: 1, T = 147.3 °C (3% Abbau), T_{MA} = 228.4 °C, Gesamtmasseabbau: 6.67 mg (78.6%).
- SDTA: (T_{S}= 25 °C, T_{E} = 600 °C, 10 °C/min, m = 8.48 mg) T_{D}(Onset) = 224.4 °C, T_{D}(max) = 231.5 °C (exotherm).

### Beispiel 7 - Darstellung und Charakterisierung von [RuH(p-cymol)(bima)]

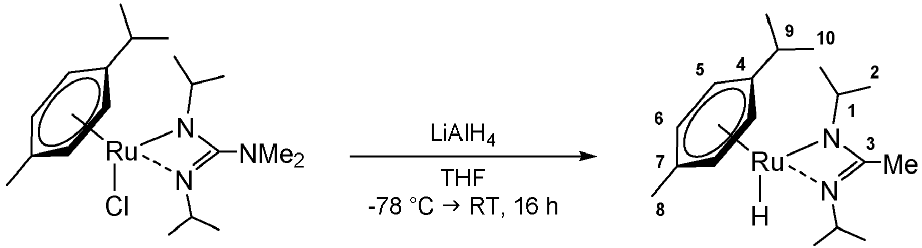

[RuCl(*p*-cymol)(bima)](440 mg, 1.07 mmol, 1.0 eq) und LiAlH₄ (20.0 mg, 0.53 mmol, 0.5 eq) wurden in THF (40 mL) bei -78 °C vorgelegt und über einen Zeitraum von 16 Stunden gerührt, wobei das Gemisch Raumtemperatur erreichen konnte. Anschließend wurde zur Vervollständigung des Umsatzes zusätzlich für 24 Stunden unter Rückflussbedingungen erhitzt. Alle flüchtigen Bestandteile wurden in Feinvakuum entfernt und der Rückstand in *n*Hexan (15 mL) aufgenommen und über CELITE® filtriert. Der Filterkuchen wurde mit weiteren Mengen an *n*Hexan (10 mL) extrahiert und das Filtrat anschließend im Feinvakuum vom Lösungsmittel befreit. Die Verbindung [RuH(p-cymol)(bima)] wurde aus dem Rückstand im Feinvakuum bei 100 °C als braunes ÖI (117 mg, 0.31 mmol, 29%) herauskondensiert.
- ¹H-NMR: (C₆D₆, 300.2 MHz): 4.78 (d, ³J_{HH} = 5.7 Hz, 2 H, H-6), 4.71 (d, ³J_{HH} = 5.6 Hz, 2 H, H-5), 3.23 (sept, 2 H, H-1), 2.64 (sept, 1 H, H-9), 2.22 (s, 3 H, Me), 1.34 (d, ³J_{HH} = 6.9 Hz, 6 H, ⁱPr), 1.30 (s, 3 H, H-8), 1.26 (d, ³J_{HH} = 6.4 Hz, 6 H, ⁱPr), 1.13 (d, ³J_{HH} = 6.3 Hz, 6 H, ⁱPr), -3.99 (s, 1 H, RuH).
- ¹³C-NMR: (C₆D₆, 75.5 MHz): δ / ppm = 165.7 (C-3), 105.4 (C-4), 97.7 (C-7), 77.1 (C-6), 75.4 (C-5), 47.1 (C-1), 33.4 (Me), 26.4 (C-10), 25.5 (C-2), 24.4 (C-2), 21.3 (C-8), 10.9 (C-9).
- Elementaranalyse: C₁₈H₃₂N₂Ru (377.54 g/mol)
berechnet: C: 57.27%, H: 8.54%, N: 7.42%
gefunden: C: 57.45%, H: 8.41%, N: 10.05%.
Aufgrund des flüssigen Aggregatzustandes der Verbindung mussten die Proben für die Elementaranalyse in zusätzlichen Übertiegeln eingeschlossen werden, was zum Einschluss von mehr Stickstoff und folglich zur Verfälschung dieses Messwertes führt.
- IR: *ṽ*/cm⁻¹ = 3052 (w), 3052 (vs), 2960 (m), 2922 (m), 2866 (m), 1878 (m), 1649 (w), 1516 (vs), 1447 (m), 1373 (m), 1355 (m), 1331 (m), 1272 (w), 1217 (m), 1172 (m), 1146 (m), 1118 (m), 1083 (m), 1054 (w), 1016 (m), 835 (m), 812 (m), 678 (w), 624 (w), 594 (w), 544 (m), 478 (w), 448 (w).
- TGA: (T_{S} = 25 °C, T_{E} = 700 °C, 10 °C/min, m = 10.1 mg) Stufen: 1, T = 130.6 °C (3% Abbau), T_{MA} = 194.1 °C, Gesamtmasseabbau: 8.39 mg (80.2%).
- SDTA: (T_{S}= 25 °C, T_{E} = 700 °C, 10 °C/min, m = 6.50 mg) T_{D}(Onset) = 183.6 °C, T_{D}(max) = 192.4 °C (exotherm).

### Beispiel 8 (Referenz) - Darstellung und Charakterisierung von [RuCl(benzol)(bidmg)]

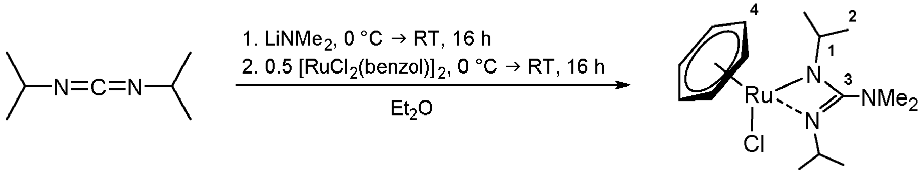

LiNMe₂ (62.4 mg, 1.20 mmol, 1.0 eq) wurde in THF vorgelegt und bei 0 °C mit N,N-Di-iso-propylcarbodiimid (151 mg, 1.20 mmol, 1.0 eq) versetzt. Das Gemisch wurde für 16 Stunden gerührt, wobei es Raumtemperatur erreichen konnte. Nach erneutem Abkühlen auf 0 °C wurde [RuCl₂(benzol)]₂ (300 mg, 0.60 mmol, 0.5 eq) zugegeben und das Gemisch für 16 Stunden gerührt, wobei es Raumtemperatur erreichen konnte. Anschließend wurde die Suspension über CELITE® filtriert und das erhaltene Filtrat im Feinvakuum getrocknet. [RuCl(benzol)(bidmg)] wurde aus dem dabei erhaltenen Rückstand mittels Sublimation (FV/120 °C) als dunkelroter Feststoff (222 mg, 0.56 mmol, 46%) erhalten.
- ¹H-NMR: (C₆D₆, 300.2 MHz): 4.96 (d, 6 H, H-6), 3.63 (sept, 2 H, H-1), 2.44 (s, 6 H, NMe₂), 1.43 (d, ³J_{HH} = 6.4 Hz, 6 H, ⁱPr), 1.27 (d, ³J_{HH} = 6.3 H_{z}, 6 H, ⁱPr).
- ¹³C-NMR: (C₆D₆, 75.5 MHz): δ / ppm = 166.8 (C-3), 81.0 (C-4), 47.7 (C-1), 40.5 (NMe₂), 26.3 (C-2), 25.5 (C-2).
- HR-EI(+)-MS: berechnet für: [M]⁺ = 385.0859 m/z, gefunden: 385.0859 m/z.
- Elementaranalyse: C₁₅H₂₆N₃ClRu (384.91 g/mol)
berechnet: C: 46.81%, H: 6.67%, N: 10.92%
gefunden: C: 47.05%, H: 6.67%, N: 10.85%.
- IR: (Substanz) *ṽ*/cm⁻¹ = 3053 (m), 2958 (m), 2915 (m), 2857 (m), 2789 (m), 1481 (vs), 1450 (s), 1416 (m), 1373 (m), 1356 (m), 1323 (m), 1194 (m), 1167 (m), 1138 (m), 1118 (m), 1059 (s), 1007 (w), 974 (m), 879 (w), 821 (s), 755 (w), 703 (w), 619 (w), 546 (w), 467 (w), 442 (w).
- TGA: (Ts = 25 °C, T_{E} = 700 °C, 10 °C/min, m = 6.50 mg) Stufen: 1, T= 152.2 °C (3% Abbau), T_{MA} = 166.7 °C (1. Prozess), T_{MA} = 243.3 °C (2. Prozess), Gesamtmasseabbau: 3.38 mg (52.0%).
- SDTA: (T_{S}= 25 °C, T_{E} = 700 °C, 10 °C/min, m = 6.50 mg) T_{M}(Onset) = 143.9 °C, T_{M}(max) = 150.0 °C (endotherm), T_{D}(Onset) = 162.6 °C, T_{D}(max) = 169.9 °C (exotherm).
- RPD: (Rückstand aus TGA-Analyse) 2θ_{Lit}^{[44]}/° (2θ_{obs} /°): 38.39 (38.34), 42.13 (42.15), 43.99 (44.01), 58.33 (58.26), 69.41 (69.34), 78.30 (n.b.), 82.22 (81.73), 84.71 (84.58), 85.96 (n.b.), 92.04 (n.b.), 97.09 (n.b.) → Nachweis: elementares Ruthenium.

### Beispiel 9 - Darstellung und Charakterisierung von [RuMe(benzol)(bidmg)]

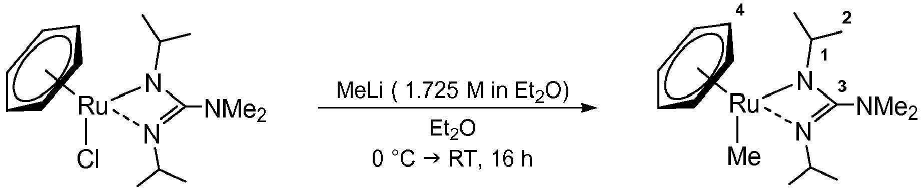

[RuCl(benzol)(bidmg)] (200 mg, 0.52 mmol, 1.0 eq) wurde in THF (10 mL) vorgelegt und bei 0 °C mit einer MeLi-Lösung (1.725 M in Et₂O, 0.33 mL, 0.52 mmol, 1.0 eq) versetzt. Das Gemisch wurde für 16 Stunden gerührt, wobei es Raumtemperatur erreichen konnte. Das Filtrat wurde im Vakuum vom Lösungsmittel befreit und der Rückstand in *n*Hexan (10 mL) aufgenommen. Die Suspension wurde über CELITE® filtriert und der Filterkuchen dabei mit weiteren Mengen an *n*Hexan (10 mL) extrahiert. Nach Eintrocknen des Filtrats im Feinvakuum wurde die Zielverbindung aus dem Rückstand herauskondensiert (FV/45 °C), wobei [RuMe(benzol)(bidmg)] als braunes ÖI (92.9 mg, 0.25 mmol, 49%), welches nach einigen Stunden erstarrte, isoliert wurde.
- ¹H-NMR: (C₆D₆, 300.2 MHz): 4.82 (s, 6 H, H-4), 3.69 (sept, 2 H, H-1), 2.48 (s, 6 H, NMe₂), 1.17 (d, ³*J*_{HH} = 6.9 Hz, 6 H, *ⁱ*Pr), 0.89 (s, 3 H, RuMe), i1.16 (d, ³*J*_{HH} = 6.4 Hz, 6 H, *ⁱ*Pr).
- ¹³C-NMR: (C₆D₆, 75.5 MHz): *δ* / ppm = 80.8 (C-4), 46.9 (C-1), 41.0 (NMe₂), 25.8 (C-2), 24.9 (C-2), 2.5 (RuMe). Die Resonanz für das quartäre Kohlenstoffatom C-3 wurde im ¹³C-NMR-Experiment nicht detektiert.
- HR-EI(+)-MS: berechnet für: [M]⁺ = 365.1405 m/z, gefunden: 365.1416 m/z.
- Elementaranalyse: C₁₆H₂₉N₃Ru (364.50 g/mol)
berechnet: C: 52.72%, H: 8.02%, N: 11.53%
gefunden: C: 53.05%, H: 7.92%, N: 11.46%.
- IR: *ṽ*/cm⁻¹ = 3065 (w), 2957 (m), 2921 (m), 2865 (m), 2785 (m), 1623 (w), 1597 (w), 1497 (vs), 1445 (s), 1415 (m), 1369 (m), 1352 (m), 1328 (m), 1277 (m), 1201 (m), 1162 (m), 1140 (m), 1117 (m), 1053 (s), 968 (m), 858 (w), 799 (w), 780 (m), 697 (w), 608 (w), 539 (w), 506 (w).
- TGA: (Ts=25 °C, T_{E} = 600 °C, 10 °C/min, m = 5.43 mg) Stufen: 1, T = 152.9 °C (3% Abbau), T_{MA} = 189.6 °C, Gesamtmasseabbau: 3.61 mg (66.3%).
- SDTA: (T_{S}= 25 °C, T_{E} = 600 °C, 10 °C/min, m = 5.43 mg) T_{M}(Onset) = 85.1 °C, T_{M}(max) = 89.6 °C (endotherm), T_{D}(Onset) = 180.7 °C, T_{D}(max) = 193.7 °C (exotherm).

### Beispiel 10 (Referenz) - Strukturelle Charakterisierung von [RuCl(p-cymol)(dmfa)]

Der Komplex [RuCl(*p*-cymol)(dmfa)] kann als Intermediat für erfindungsgemäße Komplexe mit niedrigem Molekulargewicht dienen. Der Komplex wurde röntgenographisch charakterisiert. Die Position von R¹ = H wurde in der Fourier-Analyse gefunden.

Kristalldaten aus einer Einkristallröntgenstrukturanalyse:

| | | |
|---|---|---|
| C₁₃H₂₁N₂ClRu | *M* = 341.84 g/mol | monoklin, *P*2₁/*c* |
| *a* = 10.2770(6) Å | *b* = 16.8754(10) Å | *c* = 16.2504(10) Å |
| *α* = 90° | *β* = 92.336(2)° | *γ* = 90° |
| *V* = 2815.9(3) Å³ | *Z* = 8 | |
| *D*_{calc} = 1.613 Mg/m³ | *µ* = 1.284 mm⁻¹ | *F*(000) = 1392 |
| Habitus: klare gelbe Blöcke | 0.246 • 0.099 • 0.061 mm³ | |

Die untersuchten Kristalle zeigen eine korrekte Elementaranalyse für C, H, N und Cl.

### Literatur:

[1] M. P. Coles, D. C. Swenson, R. F. Jordan, V. G. Young, Organometallics 1997, 16, 5183-5194.
[2] R. Garcia-Älvarez, F. J. Suárez, J. Díez, P. Crochet, V. Cadierno, A. Antiñolo, R. Fernández-Galán, F. Carrillo-Hermosilla, Organometallics 2012, 31, 8301-8311.

## Patentansprüche

1. Rutheniumkomplex der Formel (I):
[(aren)RuXL] Formel (I)
wobei der Rutheniumkomplex folgende Liganden aufweist:
(aren) = Aren, das optional substituiert sein kann,
X = H oder C₁-C₈ Kohlenwasserstoffrest, und
L = R²N-CR¹=NR³, wobei
R¹ ausgewählt ist aus H, C₁-C₈ Kohlenwasserstoffrest, der optional substituiert sein kann, und -NR⁴R⁵, wobei R⁴ und R⁵ unabhängig voneinander ausgewählt sind aus H und C₁-C₈ Kohlenwasserstoffresten, die optional substituiert sein können,
R² und R³ unabhängig voneinander ausgewählt sind aus C₁-C₈ Kohlenwasserstoffresten, die optional substituiert sein können, wobei R² und R³ gleich oder verschieden voneinander sind, und
R¹ mit R², R¹ mit R³ und/oder R² mit R³ direkt verknüpft sein kann.

2. Rutheniumkomplex gemäß Anspruch 1, wobei
(aren) ein mit 1 bis 6 gleichen oder verschiedenen C₁-C₈ Kohlenwasserstoffresten substituiertes Aren oder ein Aren ist,
R¹ aus H, C₁-C₈ Kohlenwasserstoffrest und -NR⁴R⁵ ausgewählt ist, wobei R⁴ und R⁵ unabhängig voneinander aus H und C₁-C₈ Kohlenwasserstoffresten ausgewählt sind, und
R² und R³ unabhängig voneinander aus C₁-C₈ Kohlenwasserstoffresten ausgewählt sind.

3. Rutheniumkomplex gemäß mindestens einem der vorhergehenden Ansprüche, wobei (aren) eine an Ru η⁶-koordinierte benzoide Struktur umfasst und/oder wobei L über den Stickstoff von R²N und über den Stickstoff von NR³ an Ru koordiniert ist.

4. Rutheniumkomplex gemäß mindestens einem der vorhergehenden Ansprüche, wobei
(aren) Benzol oder mit 1 bis 6 C₁-C₄ gleichen oder verschiedenen Kohlenwasserstoffresten substituiertes Benzol ist,
X H oder ein C₁-C₄ Kohlenwasserstoffrest ist,
R¹ H, Methyl, Ethyl, -N(Methyl)₂ oder -N(Ethyl)₂ ist, und
R², R³ jeweils ein C₁-C₄ Kohlenwasserstoffrest ist.

5. Rutheniumkomplex gemäß mindestens einem der vorhergehenden Ansprüche, wobei (aren) aus Benzol und 4-Isopropyltoluol ausgewählt ist.

6. Rutheniumkomplex gemäß mindestens einem der vorhergehenden Ansprüche, wobei X aus H, Methyl, Ethyl, Propyl, Isopropyl und tert-Butyl ausgewählt ist.

7. Rutheniumkomplex gemäß mindestens einem der vorhergehenden Ansprüche, wobei R¹ aus Methyl und -N(Methyl)₂ ausgewählt ist und/oder wobei R² und R³ unabhängig voneinander aus Methyl, Ethyl, Propyl, Isopropyl und tert-Butyl ausgewählt sind.

8. Rutheniumkomplex gemäß mindestens einem der vorhergehenden Ansprüche, wobei R¹ nicht mit R², R¹ nicht mit R³ und R² nicht mit R³ direkt verknüpft ist.

9. Rutheniumkomplex gemäß mindestens einem der vorhergehenden Ansprüche, der unter Standardbedingungen bei 25°C und 1•10⁵ Pa flüssig ist und/oder der bei einem Druck von 1,013•10⁵ Pa einen Schmelzpunkt von ≤ 25°C aufweist und/oder der bei Temperaturen im Bereich von 100 bis 200°C zerfällt.

10. Rutheniumkomplex gemäß mindestens einem der vorhergehenden Ansprüche, wobei in einer thermogravimetrischen Analyse die Temperatur eines ersten Masseabbaus von 3 Gew.-% des Rutheniumkomplexes bei 1•10⁵ Pa im Bereich von 80 bis 200°C liegt.

11. Verfahren zur Herstellung eines Rutheniumkomplexes gemäß mindestens einem der vorhergehenden Ansprüche umfassend die Schritte:
(i) Umsetzen einer Verbindung mit der Formel R²N=C=NR³ mit einer Verbindung mit der Formel Li-R¹ zur Herstellung einer Verbindung mit der Formel Li(R²N-CR¹=NR³),
(ii) Umsetzen der Verbindung Li(R²N-CR¹=NR³) mit einer Verbindung mit der Formel [RuCl₂(aren)]₂ zur Herstellung einer Verbindung mit der Formel [(aren)RuCI(R²N-CR¹=NR³)], und
(iii) Umsetzen der Verbindung [(aren)RuCI(R²N-CR¹=NR³)] mit einer Verbindung MXₙ, wobei M = Metall und n = 1, 2, 3 oder 4 ist.

12. Verfahren gemäß Anspruch 11, wobei die Verbindung Li(R²N-CR¹=NR³) *in situ* gebildet und direkt mit einer Verbindung mit der Formel [RuCl₂(aren)]₂ umgesetzt wird.

13. Verwendung eines Rutheniumkomplexes gemäß mindestens einem der Ansprüche 1 bis 10 zur Abscheidung von Ruthenium in einem CVD-Verfahren oder einem ALD-Verfahren.

14. Verfahren, in dem ein Rutheniumkomplex gemäß mindestens einem der Ansprüche 1 bis 10 als Präkursor zur Herstellung einer Rutheniumschicht verwendet wird.

15. Ruthenierte Oberfläche, erhältlich durch Abscheiden von Ruthenium auf einer Oberfläche aus einer Gasphase, die einen Rutheniumkomplex gemäß mindestens einem der Ansprüche 1 bis 10 umfasst.
